# EUROPEAN PATENT SPECIFICATION

(11) **EP 2 613 354 B1**
(45) Date of publication and mention of the grant of the patent: **06.05.2020**
(21) Application number: 12150037.5
(22) Date of filing: 03.01.2012
(51) Int. Cl.: H01L 25/075, H01L 33/48, H01L 33/50, H01L 33/58, H01L 33/60

(54) **Multi-cavaties light emitting device**
Lichtemittierende Vorrichtung mit mehreren Hohlräumen
Dispositif électroluminescent à plusieurs cavités

(43) Date of publication of application: 10.07.2013
(73) Proprietor: Epistar Corporation, Hsinchu 300 (TW)
(72) Inventor: Chou, Hsi-Yan, 32661 Yangmei, Taoyuang (TW); Cheng, Tzu-Chi, 32661 Yangmei, Taoyuang (TW)
(74) Representative: Ter Meer Steinmeister & Partner

(56) References cited:
- EP-A1- 2 211 083
- WO-A1-2005/091392
- WO-A1-2007/114614
- CN-A- 101 968 169
- DE-A1-102010 027 875
- US-A1- 2004 070 333
- US-A1- 2004 217 364
- US-A1- 2005 127 816
- US-A1- 2008 035 938
- US-A1- 2009 189 177

## Description

### FIELD OF THE INVENTION

The present invention relates to a light emitting device, in particular to a Multi-Cavities light emitting device capable of emitting a warm white light.

### BACKGROUND OF THE INVENTION

With the features of low power consumption, good power-saving effect, long service life, small volume and quick response, light emitting diodes (LED) have gradually replaced traditional tungsten bulbs, fluorescent lamps or mercury lamps, and the LEDs are applied extensively in various types of lamps.

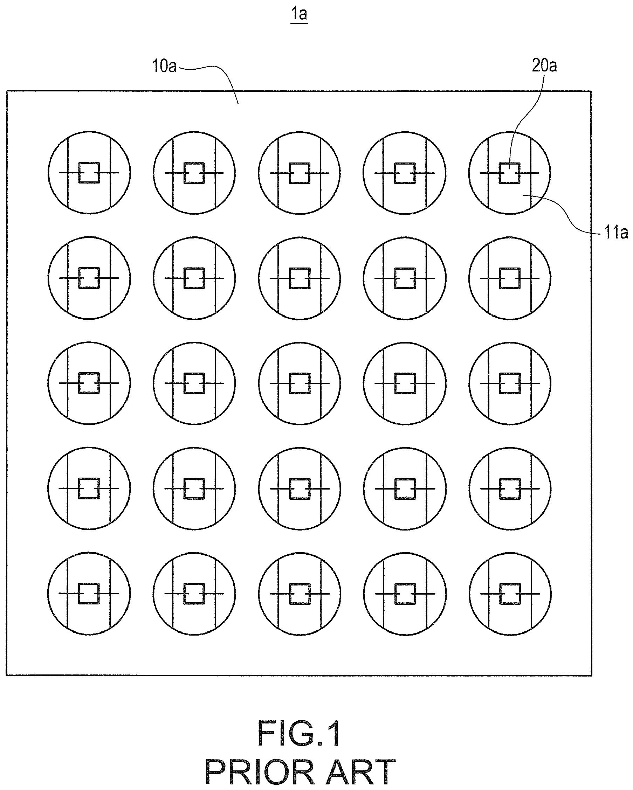

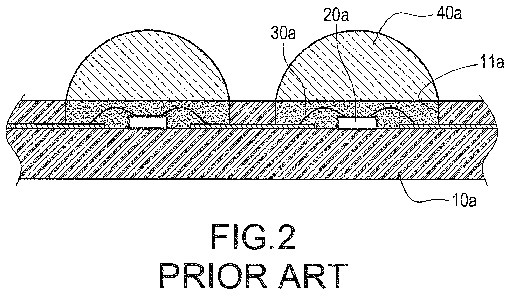

With reference to FIGS. 1 and 2 for a schematic planar view and a partial cross-sectional view of a conventional LED module respectively, the LED module 1a comprises a substrate 10a, a plurality of LED chips (such as blue LED chips) 20a, a fluorescent plastic (such as a yellow fluorescent plastic) 30a and a plurality of lenses 40a, wherein the substrate 10a includes a plurality of slots 11a arranged in a matrix, and the LED chips 20a are installed into the slots 11a respectively, and the fluorescent plastic 30a is filled into the slots 11a for covering the LED chips 20a and emitting a desired light color, and finally the lenses 40a are combined and formed onto the fluorescent plastic 30a and the LED chips 20a to seal each LED chip 20a. With the lens 40a, the light emitting efficiency of the LED chip 20a can be improved to provide a white light source.

In the foregoing structure, the lenses 40a are combined with the LED chips 20a one by one, so that the overall assembling time and cost will be increased. In addition, a large number of slots 11a are densely disposed, so that a substrate with a larger area is required, and the strength of the substrate 10a will be affected adversely, and the substrate 10a may be cracked or broken easily to result in a low yield rate.

In view of the drawbacks of the conventional LED module, the inventor of the present invention based on years of experience in the related industry to conduct extensive researches and experiments, and finally developed a feasible design to overcome the aforementioned drawbacks of the prior art.

From US 2005/0127816, US 2009/0189177, and WO 2005/091392 there is known an LED module with a plurality of slots for receiving LED chips. However, those slots are symmetrically arranged in a matrix. Such a matrix arrangement can only make regular illumination. Sometimes irregular illumination would be necessary.

US 2004/007033 A1 discloses a light emitting diode package comprising a base having a central slot and at least two side slots symmetrically formed on external sides of the central slot, a blue light emitting diode chip installed in the central slot, at least two red light emitting diode chips installed in the at least two side slots respectively, and a light conversion layer covered onto the first light emitting diode chip.

DE 10210027875 A1 discloses a light emitting diode device comprising a base having a central slot and at least two side slots symmetrically formed on external sides of the central slot, a red light emitting diode chip installed in the central slot, at least two blue light emitting diode chips installed in the at least two side slots respectively, a lens made of silicone, protruded from the base and integrally sealed onto the central slot, and at least two light conversion layers covered onto the blue light emitting diode chips.

CN 101968169 A discloses a light emitting diode package comprising a base having at least two side slots symmetrically formed on external sides of the base, a first light emitting diode chip installed centrally on the base, at least two second light emitting diode chips installed in the at least two side slots respectively, a single lens protruded from the base and integrally sealed onto the at least two side slots, and at least two light conversion layers covered onto the second light emitting diode chips.

### SUMMARY OF THE INVENTION

Therefore, it is a primary objective of the present invention to provide a Multi-Cavities light emitting device to achieve the effects of improving the light extraction efficiency of an LED chip and the yield rate of the product and reducing the overall assembling time and cost.

To achieve the aforementioned objective, the present invention provides a Multi-Cavities light emitting device according to claim 1 or claim 2.

Another objective of the present invention is to provide a Multi-Cavities light emitting device, wherein a ceramic material is used for making the base, and a gap between the central slot and each of the side slots is greater than 0.5mm to maintain the strength of the base, so as avoid the substrate from being cracked or broken, and improve the yield rate of the product.

Compared with the prior art, the light emitting device of the present invention comprises a blue LED chip covered by a plastic layer containing a yellow or green phosphor, so as to emit a warm white light. Since the red LED chip is not covered with a fluorescent plastic layer, the light extraction efficiency of the red LED chip will not be affected, and the overall light extraction efficiency of the light emitting device can be improved. In addition, the lens is integrally sealed onto the central slot and at least two side slots, and thus it is not necessary to seal the slots one by one, and the manufacturing time and labor of the light emitting device can be reduced to lower the overall cost. The invention can minimize the light emitting area effectively to facilitate a secondary optical design at a later stage, so as to provide a more practical use of the present invention,

### BRIEF DESCRIPTION OF THE DRAWINGS

FIG. 1 is a schematic planar view of a conventional LED module;
FIG. 2 is a partial cross-sectional view of a conventional LED module;
FIG. 3 is a schematic planar view of a Multi-Cavities light emitting device of the present invention;
FIG. 4 is a cross-sectional view of a Multi-Cavities light emitting device of the present invention;
FIG. 5 is a cross-sectional view of a Multi-Cavities light emitting device in accordance with another embodiment of the present invention; and
FIG. 6 is a cross-sectional view of another Multi-Cavities light emitting device in accordance with a further embodiment of the present invention.

### DESCRIPTION OF THE PREFERRED EMBODIMENTS

The technical characteristics and contents of the present invention will become apparent with the following detailed description and related drawings. The drawings are provided for the purpose of illustrating the present invention only, but not intended for limiting the scope of the invention.

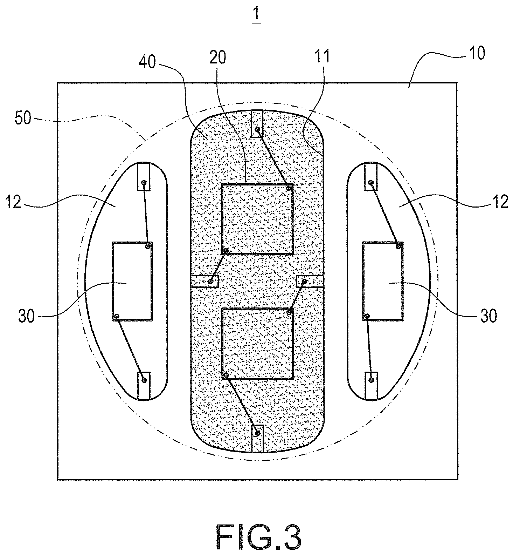

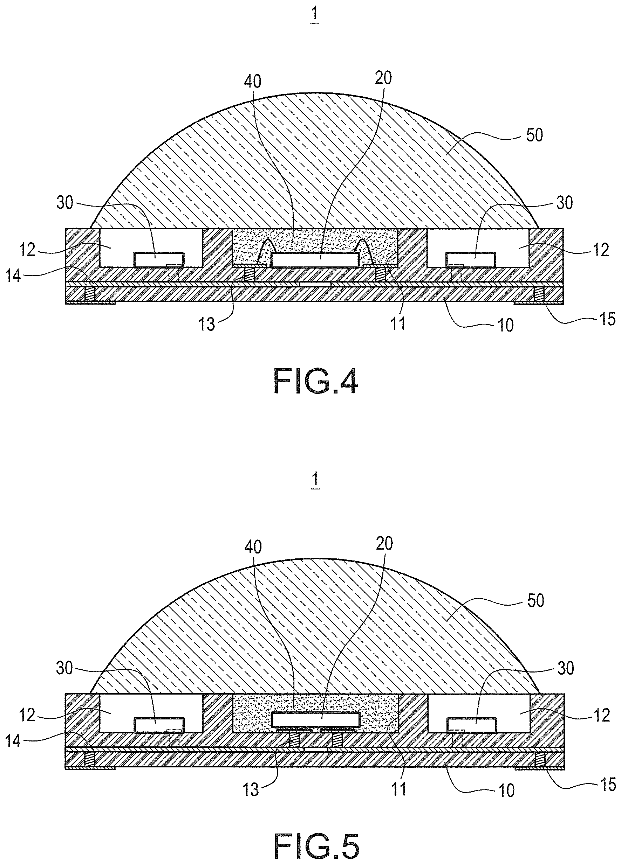

With reference to FIGS. 3 and 4 for a schematic planar view and a cross-sectional view of a Multi-Cavities light emitting device of the present invention respectively, the Multi-Cavities light emitting device 1 comprises a base 10, a first light emitting unit 20, at least two second light emitting units 30, a light conversion layer 40 and a lens 50.

The base 10 has a central slot 11 and at least two side slots 12 symmetrically formed on external sides of the central slot 11. The base 10 can be a ceramic base having a plurality of conductive holes 13 and an inner-layer circuit 14, but the invention is not limited to such arrangement of the base only.

In this preferred embodiment, the first light emitting unit 20 is a blue light emitting unit, and each of the second light emitting units 30 is a red light emitting unit, and the central slot 11 and the side slots 12 are substantially in a long elliptical shape, and a gap between the central slot 11 and each of the side slots 12 is greater than 0.5mm. In accordance with the present invention, the central slot 11 and the side slots 12 are formed in an area greater than 50% of the area of the base 10.

The first light emitting unit 20 is installed in the central slot 11, and the two second light emitting units 30 are installed into two corresponding side slots 12 respectively. The first light emitting unit 20 (which is the blue light emitting unit) and the second light emitting units 30 (which are the red light emitting units) are electrically coupled through the conductive holes 13 and the inner-layer circuit 14, and the substrate 10 includes a plurality of electric connecting pads 15 installed at the bottom of the substrate 10. In this preferred embodiment, the blue light emitting unit installed in the central slot 11 is a blue LED chip array, and the red light emitting units installed on both external sides of the blue light emitting unit are red LED chip arrays.

The light conversion layer 40 is a plastic layer containing a yellow or green phosphor, and the light conversion layer 40 is covered onto the first light emitting unit 20 (which is the blue light emitting unit). For example, yttrium aluminum garnet (YAG) is one of the yellow phosphors. After lights of the first light emitting unit 20 (which is the blue light emitting unit) and the second light emitting units 30 (which are the red light emitting units) covered with the light conversion layer 40 are collected, a warm white light is produced, wherein the warm white light has a color temperature range from 2700K to 4000K.

The lens 50 is protruded from the base for integrally sealing the central slot 11 and the at least two side slots 12, and the lens 50 is made of resin, silicone, or epoxy resin, and a diffusion agent is added into the material of the lens to form the shape of a lens naturally, so as to enhance the light extraction and mix the lights emitted from the first light emitting unit 20 (which is the blue light emitting unit) and the second light emitting units 30 (which are the red light emitting units).

With reference to FIG. 5 for a cross-sectional view of a Multi-Cavities light emitting device in accordance with another embodiment of the present invention, the difference between FIG. 5 and FIG 4 resides on that the blue light emitting unit 20 is combined into the central slot 11 by the method of a flip chip.

It is noteworthy to point out that the blue light emitting unit and the red light emitting unit can be interchangeable. In other words, the first light emitting unit 20 can be a red light emitting unit, and each of the second light emitting units 30 can be a blue light emitting unit. The red light emitting unit is installed in the central slot 11. On the other hand, the side slots 12 include the blue light emitting units installed therein respectively, and the side slots 12 are filled with the light conversion layers 40, and the light conversion layers 40 are disposed at positions corresponding to the blue light emitting units for covering the blue light emitting unit, and the lens 50 is provided for integrally sealing the central slot 11 and side slots 12, so as to complete assembling the light emitting device 1.

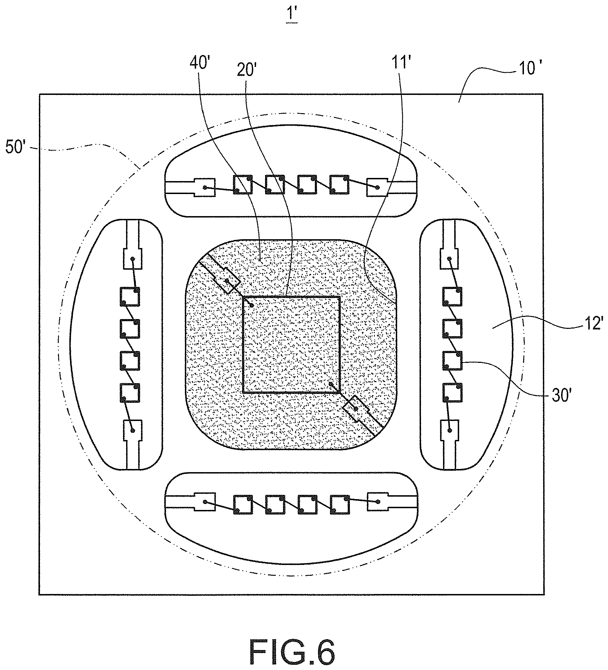

With reference to FIG. 6 for a Multi-Cavities light emitting device in accordance with another preferred embodiment of the present invention, this preferred embodiment is substantially the same as the first preferred embodiment, and the light emitting device 1' of this preferred embodiment comprises a base 10', a first light emitting unit 20' (which is a blue light emitting unit), at least four second light emitting units 30' (which are red light emitting units), a light conversion layer 40' and a lens 50'. In this preferred embodiment, the base 10' has a central slot 11' and four side slots 12', and the side slots 12' are formed around external sides of the central slot 11', wherein each side slot 12' includes a second light emitting unit 30' installed therein, and each second light emitting unit 30' (which is the red light emitting unit) includes a plurality of red LED chips connected in series with each other, and the red light emitting unit can be substituted by a red LED array.

It is noteworthy to point out that in the use of the light emitting device 1, 1' of the present invention, the quantity and position of the second light emitting units 30' and the first light emitting units 20' are not limited, so that the desired brightness and color temperature can be adjusted flexibly.

## Claims

1. A Multi-Cavities light emitting device, comprising:
a base (10, 10'), having a central slot (11, 11') and at least two side slots (12, 12') symmetrically formed on external sides of the central slot (11, 11'), and the central slot (11, 11') and the side slots (12, 12') being formed in an area greater than 50% of the area of the base (10, 10');
a first light emitting unit (20, 20'), installed in the central slot (11, 11') ;
at least two second light emitting units (30, 30'), installed in the at least two side slots (12, 12'), respectively,
a single lens (50, 50') protruded from the base (10, 10') and integrally sealed onto the central slot (11, 11') and the at least two side slots (12, 12'); and
a light conversion layer (40, 40'),
wherein the first light emitting unit (20, 20') is a blue light emitting unit and each of the second light emitting units (30, 30') is a red light emitting unit,
wherein the light conversion layer (40, 40') is covered onto the first light emitting unit (20, 20'), and
wherein the lens (50, 50') is made of resin, silicone, or epoxy resin and a diffusion agent added into the resin, silicone, or epoxy resin for mixing light emitted from the first light emitting unit (20, 20') and the second light emitting units (30, 30').

2. A Multi-Cavities light emitting device, comprising:
a base (10, 10'), having a central slot (11, 11') and at least two side slots (12, 12') symmetrically formed on external sides of the central slot (11, 11'), and the central slot (11, 11') and the side slots (12, 12') being formed in an area greater than 50% of the area of the base (10, 10');
a first light emitting unit (20, 20'), installed in the central slot (11, 11');
at least two second light emitting units (30, 30'), installed in the at least two side slots (12, 12'), respectively,
a single lens (50, 50') protruded from the base (10, 10') and integrally sealed onto the central slot (11, 11') and the at least two side slots (12, 12'); and
at least two light conversion layers (40, 40'), wherein the first light emitting unit (20, 20') is a red light emitting unit, and each of the second light emitting units (30, 30') is a blue light emitting unit, and the light conversion layers are covered onto the second light emitting units (30, 30'), and
wherein the lens (50, 50') is made of resin, silicone, or epoxy resin and a diffusion agent added into the resin, silicone, or epoxy resin for mixing light emitted from the first light emitting unit (20, 20') and the second light emitting units (30, 30').

3. The Multi-Cavities light emitting device of claim 1 or 2, wherein the base (10, 10') is a ceramic base.

4. The Multi-Cavities light emitting device of claim 3, wherein the base (10, 10') includes a plurality of conductive holes (13) and an inner-layer circuit (14), and the blue light emitting unit and the red light emitting units are electrically coupled through the conductive holes (13) and the inner-layer circuit (14).

5. The Multi-Cavities light emitting device of claim 1 or 2, wherein the central slot (11, 11') and the side slots (12, 12') are substantially formed in a long elliptical shape.

6. The Multi-Cavities light emitting device of claim 3, wherein the central slot (11, 11') and each of the side slots (12, 12') are disposed apart from each other with a gap greater than 0.5 mm.

7. The Multi-Cavities light emitting device of one of the preceding claims, wherein the base (10') includes four side slots (12') formed around external sides of the central slot (11').

8. The Multi-Cavities light emitting device of claim 1 or 2, wherein the blue light emitting unit is a blue LED chip array.

9. The Multi-Cavities light emitting device of claim 1 or 2, wherein the red light emitting unit is a red LED chip array.

10. The Multi-Cavities light emitting device of one of the preceding claims, wherein lights emitted from the first light emitting unit (20, 20') and the second light emitting units (30, 30') have a color temperature ranged from 2700K to 4000K.

11. The Multi-Cavities light emitting device of claim 1, wherein the light conversion layer (40, 40') contains a yellow phosphor.

12. The Multi-Cavities light emitting device of claim 2, wherein the at least two light conversion layers (40, 40') contain a yellow phosphor.

13. The Multi-Cavities light emitting device of claim 11 or 12, wherein the yellow phosphor is yttrium aluminum garnet.

## Patentansprüche

1. Lichtemittierende Vorrichtung mit mehreren Vertiefungen, die Folgendes umfasst:
eine Basis (10, 10'), die eine mittige Aussparung (11, 11') und mindestens zwei seitliche Aussparungen (12, 12'), die symmetrisch auf Außenseiten der mittigen Aussparung (11, 11') gebildet sind, aufweist, wobei die mittige Aussparung (11, 11') und die seitlichen Aussparungen (12, 12') in einer Fläche gebildet sind, die größer ist als 50 % der Fläche der Basis (10, 10');
eine erste lichtemittierende Einheit (20, 20'), die in die mittige Aussparung (11, 11') eingebaut ist;
mindestens zwei zweite lichtemittierende Einheiten (30, 30'), die jeweils in die mindestens zwei seitlichen Aussparungen (12, 12') eingebaut sind;
eine einzelne Linse (50, 50'), die von der Basis (10, 10') vorsteht und auf der mittigen Aussparung (11, 11') und den mindestens zwei seitlichen Aussparungen (12, 12') einteilig dicht angeordnet ist, und
ein Lichtumsetzungsschicht (40, 40'),
wobei die erste lichtemittierende Einheit (20, 20') eine blaue lichtemittierende Einheit ist und jede der zweiten lichtemittierenden Einheiten (30, 30') eine rote lichtemittierende Einheit ist,
wobei die Lichtumsetzungsschicht (40, 40') auf die erste lichtemittierende Einheit (20, 20') gesetzt ist und
wobei die Linse (50, 50') aus Harz, Silikon oder Epoxidharz hergestellt ist und ein Diffusionsmittel zu dem Harz, Silikon oder Epoxidharz hinzugefügt ist, um Licht, das von der ersten lichtemittierenden Einheit (20, 20') und den zweiten lichtemittierenden Einheiten (30, 30') emittiert wird, zu mischen.

2. Lichtemittierende Vorrichtung mit mehreren Vertiefungen, die Folgendes umfasst:
eine Basis (10, 10'), die eine mittige Aussparung (11, 11') und mindestens zwei seitliche Aussparungen (12, 12'), die symmetrisch auf Außenseiten der mittigen Aussparung (11, 11') gebildet sind, aufweist, wobei die mittige Aussparung (11, 11') und die seitlichen Aussparungen (12, 12') in einer Fläche gebildet sind, die größer ist als 50% der Fläche der Basis (10, 10');
eine erste lichtemittierende Einheit (20, 20'), die in die mittige Aussparung (11, 11') eingebaut ist;
mindestens zwei zweite lichtemittierende Einheiten (30, 30'), die jeweils in die mindestens zwei seitlichen Aussparungen (12, 12') eingebaut sind;
eine einzelne Linse (50, 50'), die von der Basis (10, 10') vorsteht und auf der mittigen Aussparung (11, 11') und den mindestens zwei seitlichen Aussparungen (12, 12') einteilig dicht angeordnet ist, und
mindestens zwei Lichtumsetzungsschichten (40, 40'),
wobei die erste lichtemittierende Einheit (20, 20') eine rote lichtemittierende Einheit ist und jede der zweiten lichtemittierenden Einheiten (30, 30') eine blaue lichtemittierende Einheit ist und die Lichtumsetzungsschichten auf die zweiten lichtemittierenden Einheiten (30, 30') gesetzt sind und
wobei die Linse (50, 50') aus Harz, Silikon oder Epoxidharz hergestellt ist und ein Diffusionsmittel zu dem Harz, Silikon oder Epoxidharz hinzugefügt ist, um Licht, das von der ersten lichtemittierenden Einheit (20, 20') und den zweiten lichtemittierenden Einheiten (30, 30') emittiert wird, zu mischen.

3. Lichtemittierende Vorrichtung mit mehreren Vertiefungen nach Anspruch 1 oder 2, wobei die Basis (10, 10') eine Basis aus Keramik ist.

4. Lichtemittierende Vorrichtung mit mehreren Vertiefungen nach Anspruch 3, wobei die Basis (10, 10') mehrere leitfähige Löcher (13) und eine Innenschichtschaltung (14) enthält und die blaue lichtemittierende Einheit und die rote lichtemittierende Einheit durch die leitfähigen Löcher (13) und die Innenschichtschaltung (14) elektrisch verbunden sind.

5. Lichtemittierende Vorrichtung mit mehreren Vertiefungen nach Anspruch 1 oder 2, wobei die mittige Aussparung (11, 11') und die seitlichen Aussparungen (12, 12') im Wesentlichen in einer länglichen elliptischen Form gebildet sind.

6. Lichtemittierende Vorrichtung mit mehreren Vertiefungen nach Anspruch 3, wobei die mittige Aussparung (11, 11') und jede der seitlichen Aussparungen (12, 12') getrennt voneinander in einem Abstand größer als 0,5 mm angeordnet sind.

7. Lichtemittierende Vorrichtung mit mehreren Vertiefungen nach einem der vorhergehenden Ansprüche, wobei die Basis (10') vier seitliche Aussparungen (12') enthält, die um Außenseiten der mittigen Aussparung (11') gebildet sind.

8. Lichtemittierende Vorrichtung mit mehreren Vertiefungen nach Anspruch 1 oder 2, wobei die blaue lichtemittierende Einheit ein blaues LED-Chipfeld ist.

9. Lichtemittierende Vorrichtung mit mehreren Vertiefungen nach Anspruch 1 oder 2, wobei die rote lichtemittierende Einheit ein rotes LED-Chipfeld ist.

10. Lichtemittierende Vorrichtung mit mehreren Vertiefungen nach einem der vorhergehenden Ansprüche, wobei Licht, das von der ersten lichtemittierenden Einheit (20, 20') und den zweiten lichtemittierenden Einheiten (30, 30') emittiert wird, eine Farbtemperatur im Bereich von 2700 K bis 4000 K aufweist.

11. Lichtemittierende Vorrichtung mit mehreren Vertiefungen nach Anspruch 1, wobei die Lichtumsetzungsschicht (40, 40') einen gelben Leuchtstoff enthält.

12. Lichtemittierende Vorrichtung mit mehreren Vertiefungen nach Anspruch 2, wobei die mindestens zwei Lichtumsetzungsschichten (40, 40') einen gelben Leuchtstoff enthalten.

13. Lichtemittierende Vorrichtung mit mehreren Vertiefungen nach Anspruch 11 oder 12, wobei der gelbe Leuchtstoff Yttrium-Aluminium-Granat ist.

## Revendications

1. Dispositif électroluminescent à cavités multiples, comportant :
une base (10, 10'), ayant une fente centrale (11, 11') et au moins deux fentes latérales (12, 12') formées symétriquement sur des côtés externes de la fente centrale (11, 11'), et la fente centrale (11, 11') et les fentes latérales (12, 12') étant formées dans une surface supérieure à 50 % de la surface de la base (10, 10') ;
une première unité émettrice de lumière (20, 20'), installée dans la fente centrale (11, 11') ;
au moins deux secondes unités émettrices de lumière (30, 30'), installées dans les au moins deux fentes latérales (12, 12'), respectivement,
une lentille unique (50, 50') faisant saillie à partir de la base (10, 10') et scellée d'un seul tenant sur la fente centrale (11, 11') et les au moins deux fentes latérales (12, 12') ; et
une couche de conversion de lumière (40, 40'),
dans lequel la première unité émettrice de lumière (20, 20') est une unité émettrice de lumière bleue et chacune des secondes unités émettrices de lumière (30, 30') est une unité émettrice de lumière rouge,
dans lequel la couche de conversion de lumière (40, 40') est recouverte sur la première unité émettrice de lumière (20, 20'), et
dans lequel la lentille (50, 50') est constituée de résine, de silicone ou de résine époxyde et d'un agent de diffusion ajouté dans la résine, la silicone ou la résine époxyde pour mélanger la lumière émise à partir de la première unité émettrice de lumière (20, 20') et des secondes unités émettrices de lumière (30, 30').

2. Dispositif électroluminescent à cavités multiples, comportant :
une base (10, 10'), ayant une fente centrale (11, 11') et au moins deux fentes latérales (12, 12') formées symétriquement sur des côtés externes de la fente centrale (11, 11'), et la fente centrale (11, 11') et les fentes latérales (12, 12') étant formées dans une surface supérieure à 50 % de la surface de la base (10, 10') ;
une première unité émettrice de lumière (20, 20'), installée dans la fente centrale (11, 11') ;
au moins deux secondes unités émettrices de lumière (30, 30'), installées dans les au moins deux fentes latérales (12, 12'), respectivement,
une lentille unique (50, 50') faisant saillie à partir de la base (10, 10') et scellée d'un seul tenant sur la fente centrale (11, 11') et les au moins deux fentes latérales (12, 12') ; et
au moins deux couches de conversion de lumière (40, 40'),
dans lequel la première unité émettrice de lumière (20, 20') est une unité émettrice de lumière rouge et chacune des secondes unités émettrice de lumière (30, 30') est une unité émettrice de lumière bleue, et les couches de conversion de lumière sont recouvertes sur les secondes unités émettrices de lumière (30, 30'), et
dans lequel la lentille (50, 50') est constituée de résine, de silicone ou de résine époxyde et d'un agent de diffusion ajouté dans la résine, la silicone ou la résine époxyde pour mélanger la lumière émise à partir de la première unité émettrice de lumière (20, 20') et des secondes unités émettrices de lumière (30, 30').

3. Dispositif électroluminescent à cavités multiples selon la revendication 1 ou 2, dans lequel la base (10, 10') est une base en céramique.

4. Dispositif électroluminescent à cavités multiples selon la revendication 3, dans lequel la base (10, 10') inclut une pluralité de trous conducteurs (13) et un circuit de couche intérieure (14), et l'unité émettrice de lumière bleue et les unités émettrices de lumière rouge sont électriquement couplées par l'intermédiaire des trous conducteurs (13) et du circuit de couche intérieure (14).

5. Dispositif électroluminescent à cavités multiples selon la revendication 1 ou 2, dans lequel la fente centrale (11, 11') et les fentes latérales (12, 12') sont pratiquement formées dans une forme elliptique longue.

6. Dispositif électroluminescent à cavités multiples selon la revendication 3, dans lequel la fente centrale (11, 11') et chacune des fentes latérales (12, 12') sont disposées espacées les unes des autres par un espace supérieur à 0,5 mm.

7. Dispositif électroluminescent à cavités multiples selon l'une des revendications précédentes, dans lequel la base (10') inclut quatre fentes latérales (12') formées autour de côtés externes de la fente centrale (11').

8. Dispositif électroluminescent à cavités multiples selon la revendication 1 ou 2, dans lequel l'unité émettrice de lumière bleue est un réseau de puces à LED bleues.

9. Dispositif électroluminescent à cavités multiples selon la revendication 1 ou 2, dans lequel l'unité émettrice de lumière rouge est un réseau de puces à LED rouges.

10. Dispositif électroluminescent à cavités multiples selon l'une des revendications précédentes, dans lequel des lumières émises à partir de la première unité émettrice de lumière (20, 20') et des secondes unités émettrices de lumière (30, 30') a une température de couleur variant de 2 700 K à 4 000 K.

11. Dispositif électroluminescent à cavités multiples selon la revendication 1, dans lequel la couche de conversion de lumière (40, 40') contient un luminophore jaune.

12. Dispositif électroluminescent à cavités multiples selon la revendication 2, dans lequel les au moins deux couches de conversion de lumière (40, 40') contiennent un luminophore jaune.

13. Dispositif électroluminescent à cavités multiples selon la revendication 11 ou 12, dans lequel le luminophore jaune est un grenat d'yttrium-aluminium.
